# EUROPEAN PATENT APPLICATION

(11) **EP 2 093 923 A1**
(43) Date of publication of application: **26.08.2009**
(21) Application number: 08715404.3
(22) Date of filing: 03.04.2008
(51) Int. Cl.: H04L 1/22

(54) **TRANSMITTING, RECEIVING METHOD AND APPARATUS FOR REALIZING SERVICE DATA RECOVERY**

(30) Priority: 21.06.2007 CN 200710117687
(71) Applicant: Huawei Technologies Co., Ltd., Longgang District, Shenzhen Guangdong Province 518129 (CN)
(72) Inventor: XIANG, Hui, Shenzhen, Guangdong Province 518129 (CN)
(74) Representative: Pfenning, Meinig & Partner GbR
(86) International application number: PCT/CN2008/070672
(87) International publication number: WO 2008/154826

(57) **Abstract**

A sending method, a receiving method, a sending apparatus, and a receiving apparatus for implementing service data recovery are disclosed, a channel protection method for channels which fail, and a channel protection system with the corresponding sending apparatus and receiving apparatus are disclosed. The channel protection method includes: performing in-band redundancy coding for each service channel that transmits service information; using at least one out-band channel as a protection channel; performing error correction for the service channel through in-band redundancy coding when the service channel generates random or correctible errors; and correcting errors of the service channel through a protection channel when the service channel fails or generates non-correctible errors. The embodiments of the present invention overcome the transient interruption of services inevitable in the prior art, overcome the inability of protection against both minor errors and major errors in the prior art, improve the reliability of communication networks and equipment greatly, and implement flexible protection for minor and major systems.

## Description

### FIELD OF THE INVENTION

The present invention relates to network communication technologies, and in particular, to a sending method, a receiving method, a sending apparatus, and a receiving apparatus for implementing service data recovery, and to a channel protection method and a channel protection system.

### BACKGROUND

In the communication technologies, in order to provide stable and reliable end-to-end communication services, the reliability of the communication channel needs to be improved, and the fault rate of the communication channel needs to be reduced. However, many inevitable interference factors exist in the actual communication environment, for example, fiber cut, too high optical loss, and optical signal interference in the optical communication, which bring minor errors, major errors and even failure of the communication channel. Therefore, an important concern in modern communication technology is how to reduce or avoid impact exerted by various interference factors onto the communication channel.

In the existing end-to-end communication service, the following two methods are applied to avoid or reduce impact exerted by interference onto the communication channel, improve the reliability of the communication channel, and reduce the fault rate.

Data link Forward Error Correction (FEC) coding is performed. Redundancy transcoding is performed beforehand for the service information that needs to be transmitted, and errors are corrected by adding extra information bandwidth. For example, the 64/66B coding in the 10GE and the FEC in the Optical Transport Network (OTN) are data channel-associated FEC.

In the process of developing the present invention, the inventor finds that the first method involves at least these problems: Minor errors of the communication channel can be detected and corrected, but the communication service cannot be recovered when the communication channel fails or suffers major errors.

An extra protection channel is provided. When the working channel is detected as faulty, the service is switched onto the protection channel. In the process of developing the present invention, the inventor finds that the second method involves at least these problems: The service is unable to be switched onto the protection channel when the working channel fails, and to recover from the fault as soon as possible. However, the protection is performed only after the fault is detected, and the transient interruption of the service is not avoided. Besides, in order to prevent frequent misoperations, the service switching is generally delayed for a certain time and is not started until the quality deterioration of the communication channel reaches a specific extent. Consequently, no effective protection is provided for minor errors.

### SUMMARY

In the first aspect, a sending method and a receiving method for implementing service data recovery are disclosed in an embodiment of the present invention to implement service data recovery in the case of minor errors, major errors and channel failure.

In the second aspect, a sending apparatus and a receiving apparatus for implementing service data recovery are disclosed in an embodiment of the present invention to implement service data recovery in the case of minor errors, major errors and channel failure.

In the third aspect, a method and a system of channel protection are disclosed in an embodiment of the present invention to enable service recovery in the case of minor errors, major errors and channel failure and implement protection in the case of failure of multiple channels.

In order to fulfill the first aspect of the present invention, a sending method for implementing service data recovery in an embodiment of the present invention is provided, and the method is as follows:
performing in-band redundancy coding for service information of each service channel;
using at least one out-band channel as a protection channel; and
sending the information of the service channel after the in-band redundancy coding,
where the in-band redundancy coding is adapted for data recovery of in-band correctible errors of the service channel or for detecting non-correctible errors or channel failure generated by the service channel, and the protection channel is adapted to recover correct data of the service channel that fails or generates non-correctible errors.

A receiving method for implementing service data recovery in an embodiment of the present invention includes:
receiving information from a service channel and/or a protection channel, and performing data check for the received information;
performing error correction for the information received by the service channel through in-band redundancy coding of the service channel when the service channel generates random or correctible errors, and recovering correct data information; and
recovering correct data information of the service channel through a protection channel when the service channel fails or generates non-correctible errors.

In the sending method and receiving method for implementing service data recovery above, in-band redundancy coding is performed for each service channel, and a protection channel is added. Therefore, minor errors are corrected through the in-band redundancy inside each service channel; and, if non-correctible errors occur in the case of major errors or channel failure, data recovery is performed through the protection channel for the service channel that generates major errors or channel failure. In this way, lossless sending and receiving of services are implemented for the scenarios of minor errors, major errors and channel failure.

In order to fulfill the second aspect of the present invention, a sending apparatus for implementing service data recovery in an embodiment of the present invention includes:
a first module, adapted to perform in-band redundancy coding for service information of each service channel;
a second module, adapted to use at least one out-band channel as a protection channel;
a third module, adapted to send the information of the service channel after the in-band redundancy coding, where the in-band redundancy coding is used for data recovery of in-band correctible errors of the service channel or for detecting non-correctible errors or channel failure generated by the service channel; and
the protection channel, adapted to recover correct data of the service channel that fails or generates non-correctible errors.

A receiving apparatus for implementing service data recovery in an embodiment of the present invention includes:
a first unit, adapted to: receive information from a service channel and/or a protection channel, and perform data check for the received information; and
a second unit, adapted to: perform data recovery for correctible error information of the service channel through in-band redundancy coding of the service channel, and recover, through a protection channel, correct service information of the service channel that fails or generates non-correctible errors.

In the sending apparatus and the receiving apparatus for implementing service data recovery described above, through the in-band redundancy coding of the service channel, data recovery is performed for correctible errors of each service channel, or non-correctible errors or channel failure is detected; and through the protection channel, data recovery is performed for the service channel that fails or generates non-correctible errors.

In order to fulfill the third aspect of the present invention, a channel protection method in an embodiment of the present invention includes:
performing in-band redundancy coding for each service channel that transmits service information;
using at least one out-band channel as a protection channel;
performing error correction for the service channel through in-band redundancy coding of the service channel when the service channel generates random or correctible errors, and recovering correct data information; and
recovering correct data of the service channel through a protection channel when the service channel fails or generates non-correctible errors.

A channel protection system in an embodiment of the present invention includes the sending apparatus, the receiving apparatus, and at least one protection channel described above. The protection channel is a redundancy check channel and/or an idle protection channel. The redundancy check channel is a protection channel generated after hybrid redundancy coding is performed for the service information of all service channels. The idle protection channel is a protection channel that serves as a substitute when the service channel fails or generates non-correctible errors.

In the embodiments of the present invention, service information is transmitted by using in-band redundancy error correction and protection channels; lossless transmission of services is implemented in the case of minor errors, major errors and channel failure; transient interruption of services inevitable in the prior art is avoided herein; the inability of protection against both minor errors and major errors in the prior art is overcome; and the reliability of communication networks and equipment is improved greatly. Moreover, the present invention does not impose special limitation on quantity of protection channels, and is capable of protecting both minor and major systems flexibly.

### BRIEF DESCRIPTION OF THE DRAWINGS

FIG. 1 shows a 4+1 channel protection method and system in an embodiment of the third aspect of the present invention;

FIG. 2 shows a 4+1 sending method in an embodiment of the first aspect of the present invention;

FIG. 3 shows a receiving method in an embodiment of the second aspect of the present invention;

FIG. 4 shows a receiving method in another embodiment of the second aspect of the present invention;

FIG. 5 shows a 4+2 channel protection method and system in another embodiment of the third aspect of the present invention;

FIG. 6 and FIG. 7 show a lossless channel protection method and system in the case that channel-D shown in FIG. 5 fails;

FIG. 8 shows a lossless channel protection method and system in the case that both channels shown in FIG. 5 fail;

FIG. 9 shows a lossless protection method and system in the case that channel-D shown in FIG. 8 recovers;

FIG. 10 shows a lossless protection method and system for channel-C shown in FIG. 9;

FIG. 11 shows redundancy coding error correction in the prior art; and

FIG. 12 shows a protection mode of a protection channel in the prior art.

### DETAILED DESCRIPTION

The technical solution under the present invention is detailed below by reference to accompanying drawings and preferred embodiments.

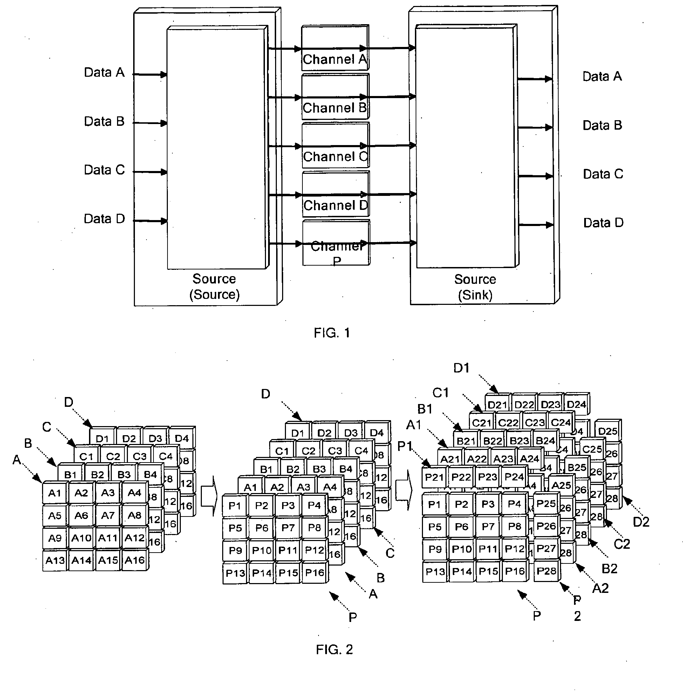

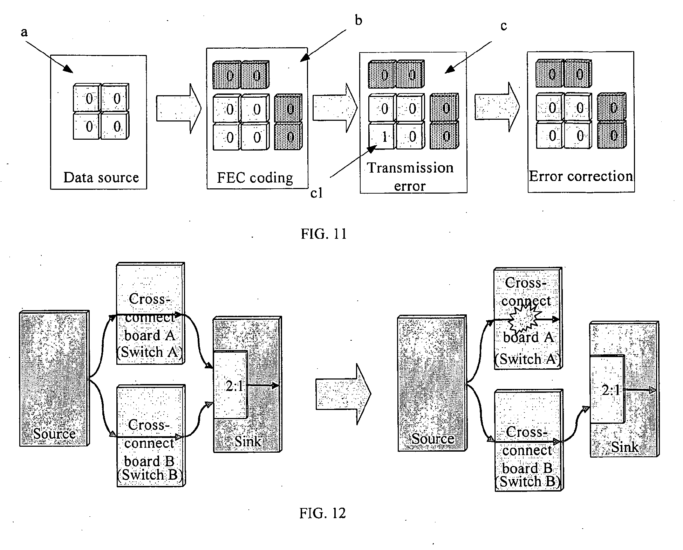

FIG. 11 shows redundancy coding error correction in the prior art. As shown in FIG. 11, in order to transmit the original data composed of four 0s (for example, the data in part of FIG. 1) more reliably in the existing redundancy coding error correction method, redundancy coding is performed at the source. For example, parity check is performed by rows or columns to obtain the check code composed of four 0s, as shown in part b (four filled data) of FIG. 1. Supposing that interference occurs in the transmission process (for example, a datum c1 in part c of FIG. 1 is erroneous in the transmission process), one of the data bits is changed to "1". Row-column check (parity check by rows or columns) is performed at the sink to obtain check errors in the second row and the first column. It is determined that the bit in the second row and the first column is erroneous, and this bit is corrected.

FIG. 12 shows a protection mode of a protection channel in the prior art. As shown in FIG. 12, in the existing protection mode of a protection channel, the cross-connect board "1+1 protection" is applied to the Synchronous Digital Hierarchy (SDH) transmission device, and the service channel from the sending apparatus (also known as a source) transmits information to the receiving apparatus (also known as a sink) through switch A and switch B of the cross-connect board. When switch A and switch B work normally, the sink chooses to receive the service from switch A. If switch A fails at a moment and this channel is blocked, the sink detects the signal quality of the channel and finds that the channel of switch A fails, and therefore, performs channel switching. As a result, the service is switched to the channel of switch B, thus protecting the communication channel.

It is thus evident that neither of the two solutions in the prior art is capable of recovering the communication service in the case that minor errors, major errors and channel failure occur at the same time. The following embodiments of the present invention provide the solution to lossless sending and receiving of services in the case of minor errors, major errors and channel failure.

The present invention comes in many embodiments. The technical solution under the present invention is exemplified below by reference to accompanying FIG. 1 - FIG. 10. The application instance of the present invention is not limited to any specific embodiment. It is understandable to those skilled in the art that the solutions described below are only for the exemplary purpose only, and the protection scope of the present invention covers all the ideas about sending and receiving service channel information and/or performing error correction through in-band redundancy coding for the service channel and through adding at least one protection channel.

FIG. 1 shows a 4+1 channel protection method and system in an embodiment of the third aspect of the present invention. This embodiment supposes that the channel protection is performed through four service channels and one protection channel. As shown in FIG. 1, the four service channels are channels A, B, C, and D; and the protection channel is channel P.

As shown in FIG. 1, depending on the protection channel P, the channel protection method falls into two types:

Type One: The protection channel P is an idle protection channel.

In-band redundancy coding such as Forward Error Correction (FEC) coding, Cyclic Redundancy Coding (CRC) and parity check is performed inside the four service channels A, B, C and D. Redundant codes are added into the service data A, B, C and D of each service channel, and then the data are transmitted over channels A, B, C and D.

Two types of errors may occur in the transmission process. When correctible errors (such as random minor errors and correctible continuous errors) occur on a service channel, the errors are corrected through in-band redundancy coding inside the service channel. When non-correctible errors (such as non-correctible continuous errors and channel failure) occur on the service channel, the in-band redundancy coding is unable to correct the errors. In this case, the sink detects the failure alarm information of this channel, and returns the failure alarm information to the source. The source backs up the service data information of the channel to the protection channel P. In this way, the protection channel P replaces the service channel. At non-service data time, the protection channel is connected to the receiving port of the service channel of the sink. After the service channel that generates the errors or channel failure recovers to normal, the protection channel is replaced by the recovered service channel at non-service data time, thus accomplishing data recovery of the service channel.

Type Two: The protection channel P is a redundancy check channel.

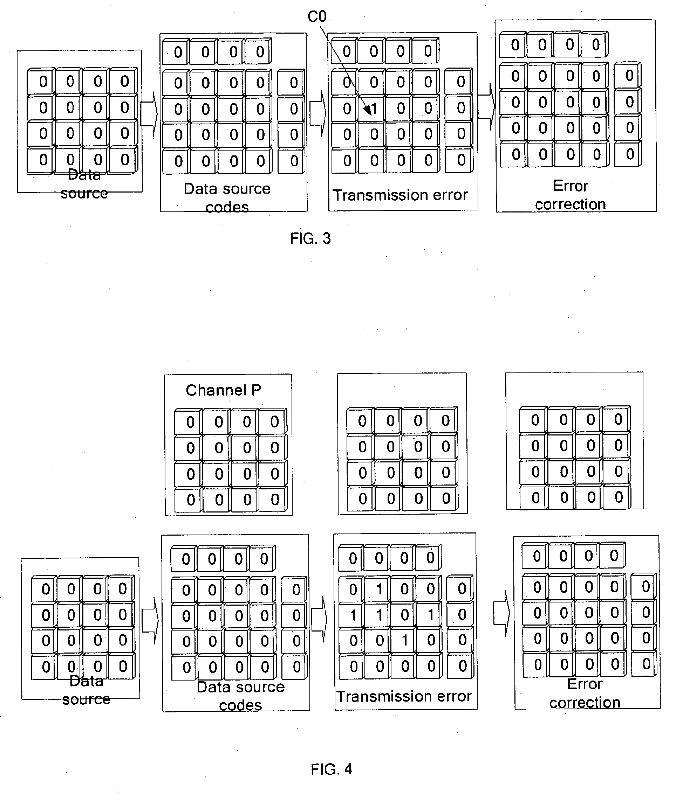

The method and the system of sending, receiving and channel protection in the case that the protection channel P is a redundancy check channel are described below by reference to FIG. 1 and FIG. 4:

A. Source: The data of four service channels are denoted by parts A, B, C and D of FIG. 2, where A represents A1...A16, B represents B1...B16, C represents C1...C16, and D represents D1...D16. Two types of redundancy conversion are performed for the service data of four service channels simultaneously.

The first type of redundancy conversion is: Hybrid redundancy coding is performed for the service data of all service channels to generate an out-band redundancy check channel P, as shown in part P of FIG. 2. P can apply multi-modal hybrid redundancy coding to the service data of all service channels, for example, perform parity check for the service data in each counterpart position of all service channels to generate redundancy check data Pn in the corresponding position of channel P, where Pn = An^bn^Cn^Dn. P can also perform other types of redundancy coding such as FEC or CRC coding for the service channel to generate the corresponding redundancy check data Pn. It is understandable to those skilled in the art that: The hybrid codes generated by the redundancy check channel P are related to the service data information of all service channels. Hybrid codes come in many modes, which are not enumerated here. After the hybrid redundancy coding, the data P1...P16 of channel P are generated.

The second type of redundancy conversion is: In-band redundancy coding is performed within all service channels A, B, C and D and the protection channel P. Parity check is performed for all service channels A, B, C and D and the redundancy check protection channel P by rows or columns to generate in-band redundant codes A21...A28/B21...B28/C21...C28/D21...D28/P21...P28. In FIG. 2, A1 refers to the in-band redundant codes generated through parity check for each column of part A, and A2 refers to the in-band redundant codes generated through parity check for each row of part A, and so on. The four service channels change to 4+1=5 channels (A, B, C, D, and P). The information on the five channels is transmitted to the sink through five channels A, B, C, D and P.

Two types of errors may occur in the transmission process. Correctible errors (such as random minor errors and correctible continuous errors) that occur in the transmission process are corrected through the in-band redundancy coding of the service channel or protection channel. As shown in FIG. 3, supposing that the data to be transmitted on a channel (A, B, C, D, or P) are sixteen 0s, redundant codes of the channel are obtained through in-band redundancy coding. That is, the parity check bits of rows or columns are also eight 0s. If an error bit is caused by random interference in the transmission process, for example, if the bit in the C0 position changes to "1", the error bit can be determined through in-band redundancy coding check at the sink (in view of the corresponding row/column check error). Therefore, the error bit is corrected by being negated.

B. Sink: In the case that non-correctible errors (such as non-correctible continuous errors or channel failure) occur on the service channel in the transmission process, the in-band redundancy coding is unable to correct the errors. In this case, the sink corrects the errors on the service channel through the protection channel P and the in-band redundancy coding of the service channel. In this way, the correct data information of the service channel is recovered. As shown in FIG. 4, supposing that the data to be transmitted on a channel (A, B, C, or D) are sixteen 0s, in-band redundant codes (namely, eight 0s) of the channel are obtained through redundancy coding. Sometimes channel failure or major errors (many data change to 1s) occur in the transmission process, and the in-band redundancy coding is unable to make correction but can detect row or column check errors. In this case, the data of the remaining three correctible erroneous service channels and the check data (Pn = An^bn^Cn^Dn) of the redundancy check channel P are taken into consideration. For example, if channel D fails, through the in-band redundant codes of channel D, a judgment is made about in which row and column of channel D the bit is erroneous. Afterward, the data on channel D can be recovered through the data on channels A, B, C, and P. In this way, the errors are corrected (by default, it is assumed that only one service channel fails at a time and other service channels have no non-correctible errors).

The protection channel under the present invention may be an extra idle channel to perform channel replacement and service information backup when a service channel fails or suffers non-correctible errors, or may be an additional redundancy check channel generated after hybrid redundancy coding is performed for the service information of all service channels. When the service channel fails or suffers from non-correctible errors, data recovery may be performed for the service channel that generates errors through the redundancy check channel, thus accomplishing lossless protection in the case of channel failure. After the service channel that fails or generates errors is recovered to normal, the service data is transmitted through the recovered service channel.

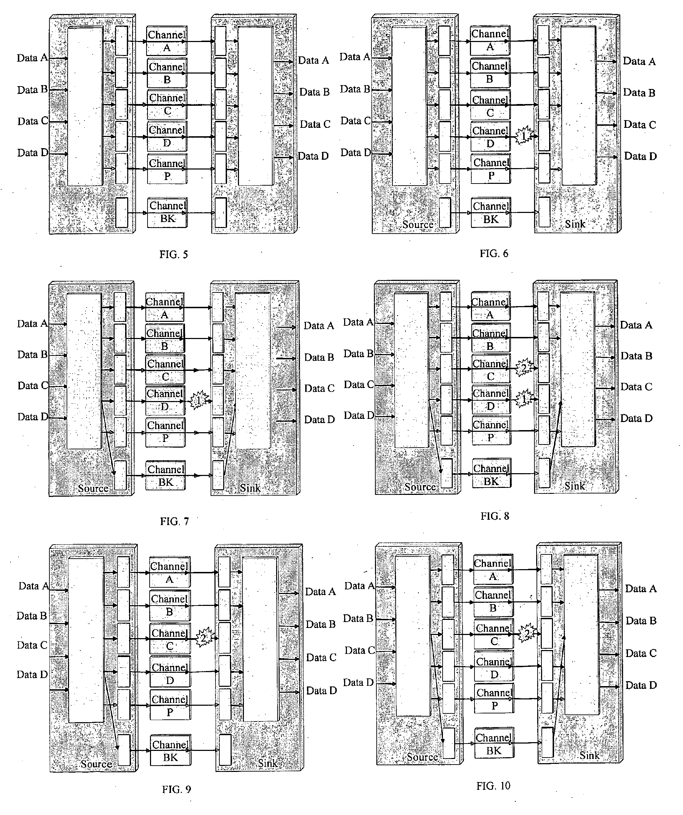

FIG. 5 shows a 4+2 lossless channel protection method and system in another embodiment of the third aspect of the present invention, where "4+2" represents four service channels in addition to two protection channels. The lossless protection method and system implemented when two service channels fail consecutively in a period are illustrated below by reference to FIG. 5 - FIG. 10:

During normal working of the channel, in-band redundancy coding is performed for the service data A, B, C and D, and a redundancy check channel P is generated. The other protection channel BK is idle. As shown in FIG. 5, the five channels send data to the sink.

Supposing that channel D fails at a moment, the sink recovers the service data A, B, C and D through redundancy error correction of A, B, C, D and P. As shown in FIG. 6, channel D fails, and the service data are recovered through channel P. Other minor errors are corrected through in-band redundancy coding inside each channel to recover the correct data.

After detecting failure of channel D, the sink sends the failure alarm information to the source. The source switches the data on channel D to the idle protection channel BK. As shown in FIG. 7, after the sink receives the backup data and determines the data as backup data of channel D, the sink switches the data on the protection channel BK to the receiving port of channel D at the non-service data time, thus ensuring lossless switching of the channel.

As shown in FIG. 8, if channel C fails when channel D has not recovered yet, at the sink, only channel C fails because channel D has been replaced by the protection channel BK at this time, and errors on channel C can still be corrected through the hybrid redundant codes of channel P and channels A, B, and BK, thus .recovering correct data of channel C and accomplishing lossless protection of the failed channel C.

Data recovery after recovery of channel D: Supposing that channel D recovers later, the sink switches the data at the receiving port of channel BK back to channel D at the non-service data time, as shown in FIG. 9. Meanwhile, information about recovery of channel D is sent to the source.

After receiving the information about recovery of channel D, the source switches the data on the idle protection channel BK to channel C. After receiving the data and determining the data as a service of channel C, the sink switches the data on channel BK to the port of channel C of the sink, whereupon another channel failure is tolerable under lossless protection.

The foregoing embodiments describe the mode of lossless recovery for the service channel in the case of minor errors, major errors and one failed channel, supposing that there are four service channels and one protection channel, and describe the mode of lossless recovery for the service channel in the case of minor errors, major errors and two channels which fail consecutively, supposing that there are four service channels and two protection channels. It is thus evident that the embodiments of the present invention can also implement protection when multiple service channels fail simultaneously. For example, if there are n protection channels, including 1 redundancy check channel, n-1 idle protection channels (n is an integer greater than 2), and Q service channels (Q)m, when m service channels (m is an integer greater than 1) fail or generate non-correctible errors simultaneously, the data recovery performed for the service channels through the protection channels includes the following steps:

If m< n, the m service channels that fail or generate non-correctible errors are replaced by m idle protection channels, and the service data information of the failed channels is transmitted through the substitute idle protection channels.

If m = n, the m-1 service channels that fail or generate non-correctible errors are replaced by m-1 idle protection channels. Data recovery is performed for the remaining failed service channel through the hybrid redundancy coding of the redundancy check channel, the data information of m-1 service channels backed up by in-1 idle protection channels, and the information of Q-m service channels with correctible errors.

Under the same conditions: there are n protection channels, including 1 redundancy check channel, n-1 idle protection channels (n is an integer greater than 2) and Q service channels (Q)m, when m service channels (m is an integer greater than 1) fail or generate non-correctible errors simultaneously, the lossless data recovery performed for the service channels through the protection channels includes the following steps:

If m < n, the m service channels that fail or generate non-correctible errors consecutively are replaced by the idle protection channels consecutively. During the replacement, lossless data recovery is performed for the service channels replaced by the idle protection channels through the redundancy check channel and the correct data information of the service channels that generate correctible errors.

If m = n, the m-1 service channels that fail or generate non-correctible errors are replaced by the idle protection channels consecutively. During the replacement, lossless data recovery is performed for a service channel which fails or generates non-correctible errors and is not replaced by an idle protection channel through the hybrid redundancy coding of the redundancy check channel, the data information of service channels backed up by the idle protection channels, and the correct data information of service channels with correctible errors.

In practice, the service channels usually fail consecutively, and it is little possible that two or more service channels fail simultaneously. Therefore, the solution to two or more service channels which fail simultaneously is applied in a narrow scope, and is not exemplified here.

It is understandable to those skilled in the art that if higher equipment reliability is expected, the recovery of multiple failed channels may be performed by adding more protection channels, and the foregoing embodiments may have diversified variations. The protection scope of the present invention covers all the ideas about sending and receiving service information and/or performing error correction through in-band redundancy coding for the service channel and through adding at least one protection channel.

In the embodiments of the present invention, service information is transmitted by using in-band redundancy error correction and protection channels; lossless transmission of services is implemented in the case of minor errors, major errors and channel failure; transient interruption of services inevitable in the prior art is avoided herein; the inability of protection against both minor errors and major errors in the prior art is overcome; and the reliability of communication networks and equipment is improved greatly. Moreover, the present invention does not impose special limitation on quantity of protection channels, but implements multiple sending, receiving and protection modes such as 1+1, m+1, m+n, and Q+n, implements lossless protection in the case that multiple channels fail consecutively, and implements flexible protection for minor and major systems.

It is understandable to those skilled in the art that all or part of the steps of the foregoing embodiments may be implemented through hardware instructed by a program or through hardware solely. When they are implemented by hardware instructed by a program, the program may be stored in a computer-readable storage medium. When being executed, the program includes the following steps:
performing in-band redundancy coding for service information of each service channel;
using at least one out-band channel as a protection channel; and
sending the information of the service channel after the in-band redundancy coding.

Alternatively, the program includes the following steps:
receiving information from a service channel and a protection channel, and performing code check for the received information;
performing error correction for the received information through in-band redundancy coding of the service channel when the service channel generates random or correctible errors;
recovering correct data information; and
recovering correct data information of the service channel through a protection channel when the service channel fails or generates non-correctible errors.

If the protection channel is a redundancy check channel, the recovering of the correct data information of the service channel through a protection channel when the service channel fails or generates the non-correctible errors is:
detecting the non-correctible errors or failure of the service channel through the in-band redundancy coding for the service channel;
correcting errors of the service channel through the received hybrid redundant codes of the redundancy check channel and the information of the service channel with correctible errors; and
recovering the correct data information of the service channel.

If the protection channel is an idle protection channel, the recovering of the correct data information of the service channel through a protection channel when the service channel fails or generates the non-correctible errors is:
detecting the non-correctible errors or failure of the service channel through the in-band redundancy coding for the service channel, receiving the information of the service channel backed up in the idle protection channel, and recovering correct data information of the service channel; and
performing, if the quantity of service channels which fail or generate the non-correctible errors is greater than the quantity of idle protection channels, error correction for the service channels that fail or generate the non-correctible errors and are not replaced by the idle protection channels through the received hybrid redundancy codes of the redundancy check channel, the service information of service channels backed up by the idle protection channels, and the information of the service channel with correctible errors, and recovering the correct data information of service channels that fail or generate the non-correctible errors and are not replaced by the idle protection channels.

Alternatively, the program includes the following steps:
performing in-band redundancy coding for each service channel that transmits service information;
using at least one out-band channel as a protection channel;
performing error correction for the service channel through in-band redundancy coding when the service channel generates random or correctible errors; and
correcting errors of the service channel through a protection channel when the service channel fails or generates non-correctible errors.

The program further includes:
performing hybrid redundancy coding for the service information of all service channels, and generating an out-band redundancy check channel as a protection channel.

The correcting of errors of the service channel through a protection channel when the service channel fails or generates non-correctible errors includes:
performing error correction for the service channel through the hybrid redundancy coding of the redundancy check channel and the information of the service channel with correctible errors.

It is understandable to those skilled in the art that all or part of the steps of the foregoing embodiments may be implemented by hardware instructed by a program. The program may be stored in a computer-readable storage medium. When being executed, the program performs the steps that cover the foregoing method embodiments. The storage medium may be any medium capable of storing program codes, for example, Read-Only Memory (ROM), Random Access Memory (RAM), magnetic disk, and compact disk.

A computer-readable storage medium is disclosed herein. The storage medium includes computer program codes which are executed by a computer processor and trigger the computer processor to perform the following steps:
performing in-band redundancy coding for service information of each service channel;
using at least one out-band channel as a protection channel; and
sending the information of the service channel after the in-band redundancy coding,
where the in-band redundancy coding is used for data recovery of in-band correctible errors of the service channel or for detecting non-correctible errors or channel failure generated by the service channel, and the protection channel is adapted to recover correct data of the service channel that fails or generates non-correctible errors.

Another computer-readable storage medium is disclosed herein. The storage medium includes computer program codes which are executed by a computer processor and trigger the computer processor to perform the following steps:
receiving information from a service channel and/or a protection channel, and performing data check for the received information;
performing error correction for the information received by the service channel through in-band redundancy coding of the service channel when the service channel generates random or correctible errors, and recovering correct data information; and
recovering correct data information of the service channel through a protection channel when the service channel fails or generates non-correctible errors.

Another computer-readable storage medium is disclosed herein. The storage medium includes computer program codes which are executed by a computer processor and trigger the computer processor to perform the following steps:
performing in-band redundancy coding for each service channel that transmits service information;
using at least one out-band channel as a protection channel;
performing error correction for the service channel through in-band redundancy coding of the service channel when the service channel generates random or correctible errors, and recovering correct data information; and
recovering correct data of the service channel through a protection channel when the service channel fails or generates non-correctible errors.

Although the invention is described through some exemplary embodiments, the invention is not limited to such embodiments. It is apparent that those skilled in the art can make various modifications and variations to the invention without departing from the spirit and scope of the invention. The invention is intended to cover the modifications and variations provided that they fall in the scope of protection defined by the following claims or their equivalents.

## Claims

1. A sending method for implementing service data recovery, comprising:
performing in-band redundancy coding for service information of each service channel;
using at least one out-band channel as a protection channel; and
sending the information of the service channel after the in-band redundancy coding,
wherein:
the in-band redundancy coding is adapted for data recovery of in-band correctible errors of the service channel or for detecting non-correctible errors or channel failure generated by the service channel; and
the protection channel is adapted to recover correct data of the service channel that fails or generates non-correctible errors.

2. The sending method for implementing service data recovery according to claim 1,
wherein:
the protection channel comprises at least a redundancy check channel;
out-band hybrid redundancy coding is performed for the service information of all service channels to generate an out-band redundancy check channel as the protection channel;
the in-band redundancy coding is performed for the redundancy check channel; and
information of the redundancy check channel subsequent to the in-band redundancy coding is sent.

3. The sending method for implementing service data recovery according to claim 1,
wherein:
the protection channel comprises at least an idle protection channel;
service data of the service channel that fails or generates non-correctible errors are backed up to the idle protection channel;
the in-band redundancy coding is performed for the idle protection channel; and
the information of the idle protection channel subsequent to the in-band redundancy coding is sent.

4. A receiving method for implementing service data recovery, comprising:
receiving information from a service channel and/or a protection channel, and performing data check for the received information;
performing error correction for information received by the service channel through in-band redundancy coding of the service channel when the service channel generates random or correctible errors, and recovering correct data information; and
recovering the correct data information of the service channel through a protection channel when the service channel fails or generates non-correctible errors.

5. The receiving method for implementing service data recovery according to claim 4,
wherein if the protection channel is a redundancy check channel, the recovering of the correct data information of the service channel through the protection channel when the service channel fails or generates the non-correctible errors is:
detecting the non-correctible errors or failure of the service channel through the in-band redundancy coding for the service channel, correcting errors of the service channel through received hybrid redundant codes of the redundancy check channel and the correct data information of the service channel with correctible errors, and recovering the correct data information of the service channel.

6. The receiving method for implementing service data recovery according to claim 4,
wherein if the protection channel is an idle protection channel, the recovering of the correct data information of the service channel through the protection channel when the service channel fails or generates the non-correctible errors is:
detecting the non-correctible errors or failure of the service channel through the in-band redundancy coding for the service channel, receiving the information of the service channel backed up in the idle protection channel, and recovering the correct data information of the service channel.

7. The receiving method for implementing service data recovery according to any one of claims 4-6, wherein if the protection channel comprises at least one redundancy check channel and one idle protection channel, the recovering of the correct data information of the service channel through the protection channel when the service channel fails or generates the non-correctible errors comprises:
detecting the non-correctible errors or failure of the service channel through the in-band redundancy coding for the service channel, returning failure information of the service channel, backing up the information of the service channel to the idle protection channel, correcting the errors of the service channel through the hybrid redundant codes of the redundancy check channel and the correct data information of the service channel with correctible errors, and recovering the correct data information of the service channel.

8. The receiving method for implementing service data recovery according to claim 7,
wherein if the quantity of the service channels which fail or generate the non-correctible errors is greater than the quantity of the idle protection channels:
performing error correction for the service channels that fail or generate the non-correctible errors and are not backed up to the idle protection channels through the hybrid redundancy codes of the redundancy check channel, the information of the service channels backed up by the idle protection channels, and the correct data information of the service channel with the correctible errors; and
recovering the correct data information of the service channels that fail or generate the non-correctible errors and are not backed up to the idle protection channels.

9. A channel protection method, comprising:
performing in-band redundancy coding for each service channel that transmits service information;
using at least one out-band channel as a protection channel; and
performing error correction for the service channel through the in-band redundancy coding of the service channel when the service channel generates random or correctible errors, and recovering correct data information; and
recovering the correct data information of the service channel through the protection channel when the service channel fails or generates non-correctible errors.

10. The channel protection method of claim 9, further comprising:
out-band hybrid redundancy coding is performed for the service information of all service channels to generate an out-band redundancy check channel as the protection channel;
the recovering of the correct data information of the service channel through the protection channel when the service channel fails or generates the non-correctible errors comprises: recovering the correct data information of the service channel through hybrid redundant codes of the redundancy check channel and the correct data information of the service channel with correctible errors.

11. The channel protection method of claim 9, wherein:
the protection channel further comprises an idle protection channel; and
the recovering of the correct data information of the service channel through the protection channel when the service channel fails or generates the non-correctible errors comprises:
the service information of the service channel that fails or generates the non-correctible errors are backed up to the idle protection channel; and
the service channel that fails or generates the non-correctible errors is replaced by the idle protection channel.

12. The channel protection method according to any one of claims 9-11, wherein:
the protection channel comprises at least one redundancy check channel and n-1 idle protection channels, and n is an integer greater than 2;
when m service channels fail or generate the non-correctible errors consecutively, m is an integer greater than 1, the recovering of the correct data information of the service channels through the protection channels comprises:
if m < n, replacing the m service channels that fail or generate the non-correctible errors consecutively with the idle protection channels consecutively, and performing lossless data recovery for the service channels replaced by the idle protection channels through the redundancy check channel and the correct data information of the service channels with correctible errors; and
if m = n, replacing the m-1 service channels that fail or generate non-correctible errors with the idle protection channels consecutively, and performing the lossless data recovery for the service channel which fails or generates the non-correctible errors and is not replaced by the idle protection channel through the hybrid redundancy coding of the redundancy check channel, the data information of service channels backed up by the idle protection channels, and the correct data information of service channels with correctible errors, wherein the redundancy check channel is the protection channel generated after the hybrid redundancy coding is performed for the service information of all service channels, and the idle protection channel is the protection channel that serves as a substitute when the service channel fails or generates the non-correctible errors.

13. A sending apparatus for implementing service data recovery, comprising:
a first module, adapted to perform in-band redundancy coding for service information of each service channel;
a second module, adapted to use at least one out-band channel as a protection channel; and
a third module, adapted to send the information of the service channel after the in-band redundancy coding, wherein the in-band redundancy coding is adapted for data recovery of in-band correctible errors of the service channel or for detecting non-correctible errors or channel failure generated by the service channel, and the protection channel is adapted to recover correct data of the service channel that fails or generates the non-correctible errors.

14. The sending apparatus for implementing service data recovery according to claim 13, wherein the second module comprises:
a first submodule, adapted to perform out-band hybrid redundancy coding for the service information of all service channels to generate an out-band redundancy check channel as the protection channel.

15. The sending apparatus for implementing service data recovery according to claim 13 or claim 14, wherein the second module further comprises:
a second submodule, adapted to back up the information of the service channel that fails or generates the non-correctible errors to an idle protection channel or replace the service channel with the idle protection channel.

16. A receiving apparatus for implementing service data recovery, comprising:
a first unit, adapted to receive information from a service channel and/or a protection channel, and perform data check for the received information; and
a second unit, adapted to: perform data recovery for correctible error information of the service channel through in-band redundancy coding of the service channel; and through a protection channel, recover correct service information of the service channel that fails or generates non-correctible errors.

17. The receiving apparatus for implementing service data recovery according to claim 16, wherein if the protection channel is a redundancy check channel, the second unit comprises:
a first subunit, adapted to perform error correction for the service channel that fails or generates the non-correctible errors through hybrid redundancy codes of the redundancy check channel and correct data information of the service channel that suffers correctible errors,
wherein:
the redundancy check channel is the protection channel generated after hybrid redundancy coding is performed for the service information of all service channels.

18. The receiving apparatus for implementing service data recovery according to claim 16, wherein if the protection channel is an idle protection channel, the second unit comprises:
a second subunit, adapted to receive backup of the information of the service channel that fails or generates the non-correctible errors from the idle protection channel, and perform the data recovery for the service channel that fails or generates the non-correctible errors, wherein the idle protection channel is the protection channel that serves as a substitute when the service channel fails or generates the non-correctible errors.

19. The receiving apparatus for implementing service data recovery according to claim 16, wherein if the protection channel includes at least one redundancy check channel and at least one idle protection channel, when two or more service channels fail or generate the non-correctible errors, the second unit comprises:
a second subunit, adapted to receive backup of the information of the service channel that fails or generates the non-correctible errors from the idle protection channel, and perform the data recovery for the service channel under the backup; and
a first subunit, adapted to perform the data recovery for the service channel that fails or generates the non-correctible errors and is not replaced by the idle protection channel through hybrid redundancy codes of the redundancy check channel, the backup service channel information of the idle protection channel, and correct data information of the service channel that suffers correctible errors.

20. A channel protection system, comprising any sending apparatus specified in claims 13-15, any receiving apparatus specified in claims 16-19, and at least one protection channel,
wherein:
the protection channel is a redundancy check channel and/or an idle protection channel;
the redundancy check channel is the protection channel generated after hybrid redundancy coding is performed for service information of all service channels; and
the idle protection channel is the protection channel that serves as a substitute when the service channel fails or generates non-correctible errors.

21. A computer-readable storage medium, comprising computer program codes which are executed by a computer processor and trigger the computer processor to perform the following steps:
performing in-band redundancy coding for service information of each service channel;
using at least one out-band channel as a protection channel; and
sending information of the service channel after the in-band redundancy coding, wherein the in-band redundancy coding is adapted for data recovery of in-band correctible errors of the service channel or for detecting non-correctible errors or channel failure generated by the service channel, and the protection channel is adapted to recover correct data of the service channel that fails or generates the non-correctible errors.

22. A computer-readable storage medium, comprising computer program codes which are executed by a computer processor and trigger the computer processor to perform the following steps:
receiving information from a service channel and/or a protection channel, and performing data check for the received information;
performing error correction for information received by the service channel through in-band redundancy coding of the service channel when the service channel generates random or correctible errors, and recovering correct data information; and
recovering the correct data information of the service channel through the protection channel when the service channel fails or generates non-correctible errors.

23. A computer-readable storage medium, comprising computer program codes which are executed by a computer processor and trigger the computer processor to perform the following steps:
performing in-band redundancy coding for each service channel that transmits service information;
using at least one out-band channel as a protection channel;
performing error correction for the service channel through the in-band redundancy coding of the service channel when the service channel generates random or correctible errors, and recovering correct data information; and
recovering the correct data information of the service channel through the protection channel when the service channel fails or generates non-correctible errors.
